Europäisches Patentamt

European Patent Office

Office européen des brevets

(11) Publication number: **0 100 539**
**A2**

# EUROPEAN PATENT APPLICATION

(21) Application number: **83107498.4**

(22) Date of filing: **29.07.83**

(51) Int. Cl.³: **C 30 B 31/14**

(30) Priority: 30.07.82 JP 116019/82 U
06.09.82 JP 154780/82
08.10.82 JP 152174/82 U
08.11.82 JP 169157/82 U
29.11.82 JP 180347/82 U

(43) date of publication of application:
15.02.84 Bulletin 84/7

(84) Designated Contracting States:
DE FR GB IT NL

(71) Applicant: **TECNISCO LTD.**
**2-15 Minami Shinagawa 2-chome**
**Shinagawa-ku Tokyo(JP)**

(72) Inventor: **Sekiya, Shinji**
**9-8 Takanawa 3-chome**
**Minato-ku Tokyo(JP)**

(74) Representative: **Patentanwälte Beetz sen. - Beetz jun.**
**Timpe - Siegfried - Schmitt-Fumian**
**Steinsdorfstrasse 10**
**D-8000 München 22(DE)**

(54) Assembled device for supporting semiconductor wafers or the like.

(57) A device for supporting semiconductor wafers or the like, and a mother boat on which to place such a device. The device and the mother boat are of the assemblable type which can be assembled by combining a plurality of component parts detachably.

Fig. I

EP 0 100 539 A2

0100539

- 1 -

ASSEMBLED DEVICE FOR SUPPORTING SEMICONDUCTOR
WAFERS OR THE LIKE

FIELD OF THE INVENTION

This invention relates to a device for supporting semiconductor wafers or the like, and a mother boat for this device.

DESCRIPTION OF THE PRIOR ART

In the diffusion treatment of semiconductor wafers, it is the well-known practice to place a plurality of semiconductor wafers on a supporting device and put it in a diffusion furnace. Frequently, a plurality of such supporting devices carrying semiconductor wafers are placed on a common mother boat and the mother boat is put in a diffusion furnace. It is important that the aforesaid supporting device and mother boat should, for example, (a) be made of a material which is substantially the same as the semiconductor wafers or does not substantially react with the semiconductor wafers so as to avoid adverse effects such as adhesion and diffusion of foreign matter to and in the semiconductor wafers subjected to diffusion treatment, and (b) have resistance to high temperatures in the diffusion furnace.

In view of such requirements, the supporting device and the mother boat are generally formed of silicon or quartz glass. Since silicon is hard and brittle, it is extremely difficult, if not impossible, to suject it to complex machining, and parts made of silicon cannot be melt-adhered to each other.

In the case of silicon, therefore, it was the previous practice to subject a silicon block to relatively simple machining such as cutting and grooving and

- 2 -

thus produce a supporting device or mother boat composed of such a single block. On the other hand, since quartz glass can be melt-adhered, a supporting device or mother boat of quartz glass is produced in the prior art generally by melt-adhering a plurality of parts made of it into a unitary structure.

Conventional supporting devices or mother boats made of silicon or quartz glass have the following problems to be solved. Firstly, since supporting devices or mother boats of silicon are composed of a single silicon block subjected to relatively simple machining, they naturally require a relatively large amount of the considerably expensive material, and the cost of production becomes high. Secondly, such a supporting device or mother boat is exposed to considerable temperature variations as a result of putting it into and out of a diffusion furnace, and undergoes local damage by thermal stresses. Local damage, however, makes the entire supporting device or mother boat useless because it is of a one-piece structure or made by melt-adhesion of parts. Thirdly, particularly in the case of using quartz glass as a material, production of a supporting device or mother boat from it is relatively complex and expensive because, for example, the operation of melt-adhering parts to each other is relatively complex. Fourthly, particularly in the case of a supporting device or mother boat made of quartz glass, exposure to high temperatures in a diffusion furnace may result in softening and deformation of its melt-adhered sites.

SUMMARY OF THE INVENTION

It is a primary object of this invention to provide a novel and excellent assembled supporting device and a novel and excellent assembled mother boat,

- 3 -

which offer a solution to the aforesaid problems associated with conventional supporting devices and mother boats.

Another object of this invention is to provide an assembled supporting device and an assembled mother boat, which can be produced relatively easily with a minimum of material required and hence a considerably reduced cost of production.

Still another object of this invention is to provide an assembled supporting device and an assembled mother boat, which, in the event of local damage, can be repaired for further use only by exchanging that part which has undergone damage.

Yet another object of this invention is to provide an assembled supporting device and an assembled mother boat, which can be easily assembled and disassembled.

A further object of this invention is to provide an assembled supporting device and an assembled mother boat, which have increased heat resistance and strength.

An additional object of this invention is to provide an assembled supporting device for supporting a plurality of semiconductor wafers or the like to be treated in a vertical furnace, which can support the semiconductor wafers in the furnace in such a state that their free end portions extend inclinedly upwardly, but which, when the semiconductor wafers are loaded into the device or withdrawn from it, can handle them in a substantially upstanding state, and therefore can permit easy automation of the loading and withdrawal of the semiconductor wafers into and from the device.

Other objects of the invention and technical advantages brought about by the present invention will become apparent from the following description.

According to one aspect of this invention,

- 4 -

there is provided an assembled device for supporting semiconductor wafers or the like, said device comprising two end supports spaced from each other horizontally with a predetermined distance therebetween and at least two rods extending across said end supports with one end portion of each rod being detachably combined with one of said end supports and the other end portion thereof being detachably combined with the other end support, at least one of said rods having formed therein a plurality of holding grooves spaced longitudinally thereof.

According to another aspect of this invention, there is provided an assembled mother boat on which to place devices for supporting semiconductor wafers or the like, said boat comprising a pair of side plates spaced laterally from each other, a pair of end plates spaced from each other in the front and rear directions, and a pair of wheeel members spaced from each other in the front and rear directions, said pair of side plates being detachably combined with said pair of end plates so that their relative movements in the front and rear directions and the lateral direction can be prevented, and said pair of wheel members being located between, and rotatably combined with, said pair of side plates.

According to still another aspect of this invention, there is provided an assembled device for supporting semiconductor wafers or the like, said device comprising at least  one end support, and at least two rods each extending substantially vertically from one end portion thereof combined detachably with said end support, each of said rods having formed therein a plurality of holding grooves spaced from each other longitudinally thereof.

According to yet another aspect of this

– 5 –

invention, there is provided an assembled device for supporting semiconductor wafers or the like, said device comprising two end supports spaced from each other and at least two rods each extending across said end supports with one end portion thereof being combined detachably with one of said end supports and the other end portion being detachably combined with the other end support, each of said rods having formed therein a plurality of holding grooves spaced longitudinally thereof, and said end supports being spaced from each other vertically so that said rods extend substantially vertically.

BRIEF DESCRIPTION OF THE ACCOMPANYING DRAWINGS

Figure 1 is an exploded perspective view of one specific embodiment of the device of this invention to be applied to a lateral furnace;

Figure 2 is a sectional view taken along line II-II of Figure 1;

Figure 3 is a sectional view taken along line III-III of Figure 1;

Figure 4 is a sectional view showing the shape of holding grooves;

Figure 5 is a perspective view of the device of Figure 1 in the assembled state;

Figure 6 is a sectional view taken along line VI-VI of Figure 5;

Figure 7 is a partial exploded perspective view showing a modified example of the device of this invention to be applied to a lateral furnace;

Figure 8 is a partial top plan view showing the device of Figure 7 in the assembled state;

Figure 9 is a partial exploded perspective view showing another modified example of the device of this invention to be applied to a lateral furnace;

Figure 10 is a sectional view taken along line IX-IX of Figure 9;

Figures 11 and 12 are partial sectional views for illustrating the manner of assembling the device shown in Figure 9;

Figure 13 is a side elevation showing still another modified example of the device of this invention to be applied to a lateral furnace;

Figure 14 is an exploded perspective view of one specific embodiment of the mother boat constructed in accordance with this invention;

Figure 15 is a perspective view showing the mother boat of Figure 14 in the assembled state;

Figure 16 is a sectional view showing the state of the device of Figure 1 being placed on the mother boat of Figure 14;

Figure 17 is an exploded perspective view of one specific embodiment of the device of this invention to be applied to a vertical furnace;

Figure 18 is a perspective view of the device of Figure 17 shown in its assembled state;

Figure 19 is a sectional view taken along line XIX-XIX of Figure 18;

Figure 20 is an exploded perspective view of a modified example of the device of this invention to be applied to a vertical furnace;

Figures 21 and 22 are a top plan view and a side elevation of the device of Figure 20 shown in its assembled and laterally disposed states, respectively;

Figure 23 is a side elevation of the device of Figure 20 shown in the assembled and suspended state.

## DETAILED DESCRIPTION OF THE PREFERRED EMBODIMENTS

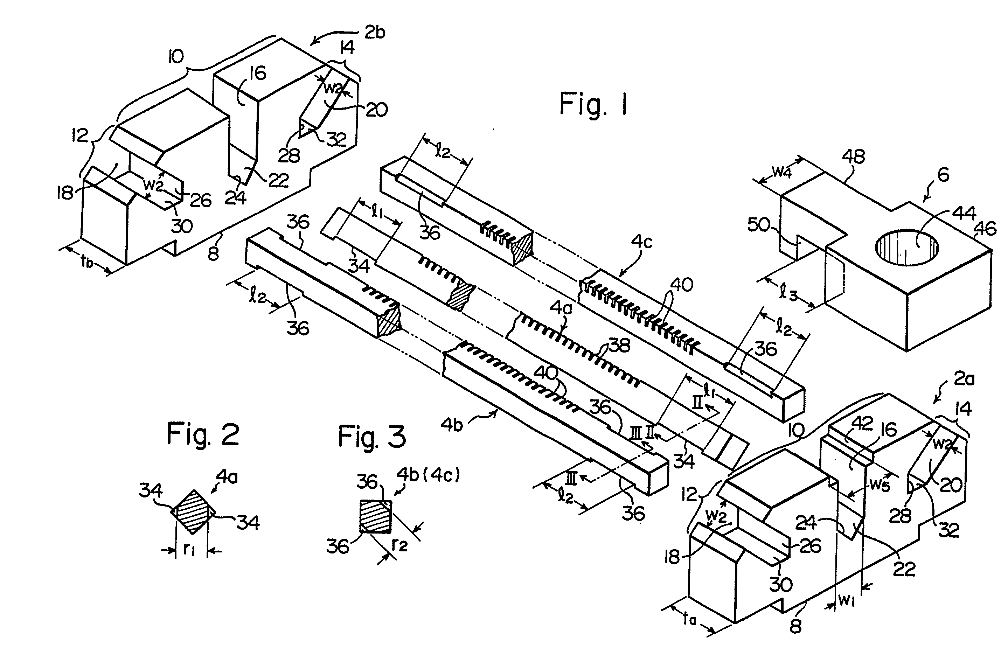

Figure 1 shows by an exploded view one specific embodiment of the assembled device of this invention for supporting semiconductor wafers or the like to be applied to a substantially horizontally extending lateral furnace. The device shown is comprised of two end supports 2a and 2b, three rods 4a, 4b and 4c, and one additional part 6.

Each of the end supports 2a and 2b may be of any suitable shape. Conveniently, it is of a wide nearly rectangular shape with a low center of gravity so as to be able to stand by itself stably. The lower end of each of the end supports 2a and 2b has formed therein a base portion 8 projecting slightly downwardly and having a substantially horizontally extending flat under surface. The upper edge of each of the end supports 2a and 2b includes a central portion 10 defined by a substantially horizontally extending flat surface and two side portions 12 and 14 defined by inclined flat surfaces inclined downwardly at a predetermined angle and extending outwardly in the widthwise direction. Each of the end supports 2a and 2b has formed therein three supporting notches, i.e. a central supporting notch 16 and side supporting notches 18 and 20, for receiving one end portions of the rods 4a, 4b and 4c, respectively. The central supporting notch 16 extends from the center of the central portion 10 downwardly and substantially vertically to a relatively deep site. Both side surfaces of the central supporting notch 16 extend substantially parallel to each other with a predetermined distance therebetween. The bottom of the central supporting notch 16 is defined by two inclined planes 22 and 24 which extend inclinedly upwardly toward both sides at an angle of about 45 degrees and reach the aforesaid both side surfaces. The side supporting notches 18 and 20 extend relatively

- 8 -

shallow, while they are inclined downwardly toward the center of each of the end supports from the two side portions 12 and 14 defined by inclined surfaces, preferably substantially perpendicular to the two side portions 12 and 14. The two side surfaces of each of the side supporting notches 18 and 20 extend substantially parallel to each other with a predetermined distance therebetween. The bottoms of the side supporting notches 18 and 20 are defined respectively by two planes, i.e. substantially vertical planes 26 and 28 and substantially horizontal planes 30 and 32.

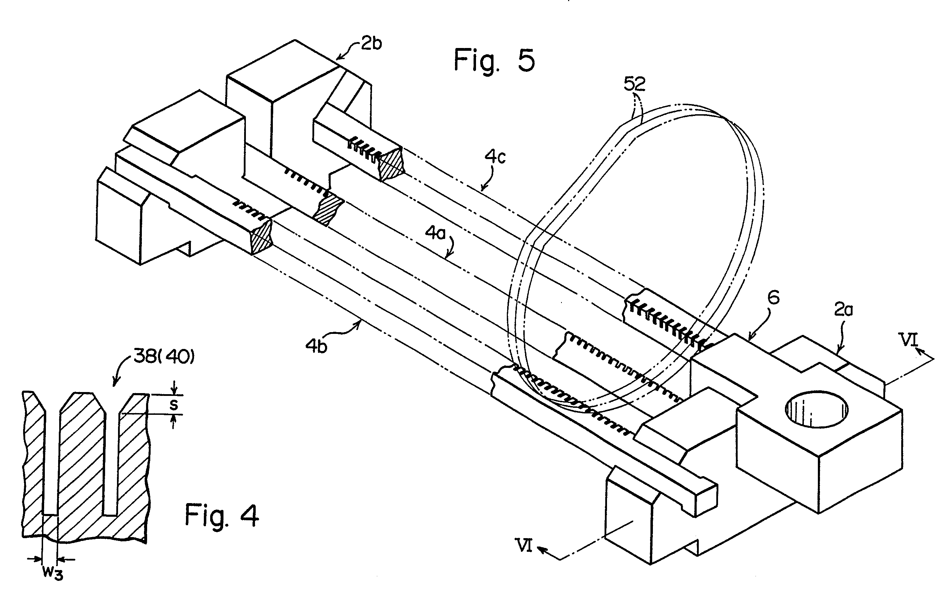

Each of the three rods 4a, 4b and 4c may have a suitable cross-sectional shape such as a circle or polygon. Preferably, it has a rectangular, particularly square, cross-sectional shape for the ease of production, and the ease of handling during assembling and disassembling. An engaging notch for engagement with each of the end supports 2a and 2b is formed at each of the opposite end portions of the three rods 4a, 4b and 4c. Referring to Figure 2 which is a sectional view taken along line II-II of Figure 1 together with Figure 1, each of the end portions of the centrally located rod 4a has formed therein two engaging notches 34 by cutting its two diagonally opposing corner portions, i.e. two corner portions located on both sides in the lateral direction in Figures 1 and 2, to provide planes substantially perpendicular to the diagonal line. The longitudinal size $\ell_1$ (Figure 1) each of such engaging notches 34 is substantially equal to, or slightly larger than, the thickness ta or tb (Figure 1) of the end supports 2a or 2b. The residual thickness rl (Figure 2) between the two engaging notches 34 is substantially equal to, or slightly smaller, than the width wl (Figure 1) of the central supporting notch 16 formed in each of the end supports 2a and 2b. With reference to Figure 3 which is a sectional view taken along line III-III of Figure 1 together with Figure 1, in each of the side portions of each of the two rods 4b and 4c located on both sides of the rod 4a, two diagonally opposing corner portions, i.e. a corner portion located at the inward top end and a corner located at the outward bottom end in Figures 1 and 3, are cut to provide substantially perpendicular planes, and thus form two engaging notches 36. The longitudinal size $\ell_2$ (Figure 1) of each of such engaging notches 36 is substantially equal to, or slightly larger than, the thickness ta or tb (Figure 1) of the end support 2a or 2b. The residual thickness r2 (Figure 3) between the two notches 36 is substantially equal to, or slighty smaller than, the width w2 (Figure 1) of each of the side supporting notches 18 and 20 formed in the end supports 2a and 2b. In the main portion of each of the three rods 4a, 4b and 4c, a plurality of holding grooves are formed at predetermined intervals in the longitudinal direction. As clearly shown in Figure 1, a plurality of holding grooves 38 longitudinally spaced from each other are formed at that corner portion of the rod 4a which is located uppermost. In the two rods 4b and 4c located on both sides, a plurality of holding grooves 40 arranged longitudinally at predetermined intervals are formed on that corner portion which is located at the inward top end of each rod. It is important that when the device of the invention is assembled by combining the three rods 4a, 4b and 4c with the two end supports 2a and 2b in the manner to be described hereinafter, the holding grooves 38 formed on the centrally located rod 4a should be positioned in lateral alignment with the holding grooves 40 formed on the two rods 4b and 4c located on both sides of the rod 4a. Each of the holding grooves 38 and 40, as is clearly shown in Figure 4, is tapered so that its width gradually decreases to a predetermined depth $s$ from its open end. From the predetermined depth to the bottom, each groove preferably has substantially the same width w3. The width w3 is substantially equal to, or slightly larger than, the thickness of a wafer or the like to be inserted in the grooves 38 and 40.

Again, with reference to Figure 1, in the illustrated embodiment, a supporting notch 42 for combining the additional part 6 is formed at the end support 2a by enlarging the width of the upper end portion of the central supporting notch 16. The additional part 6 has a main portion 46 having a vertically extending opening 44 formed therein, and an engaging portion projecting forwardly from the main portion 46. A rectangular engaging notch 50 is formed in the lower surface of the engaging portion 48. The longitudinal size $\ell_3$ of the engaging notch 50 is substantially equal to, or slightly larger than, the thickness ta of the end support 2a. The width w4 in the lateral direction of the engaging portion 48 is substantially equal to, or slightly smaller than, the width w5 of the enlarged supporting notch 42.

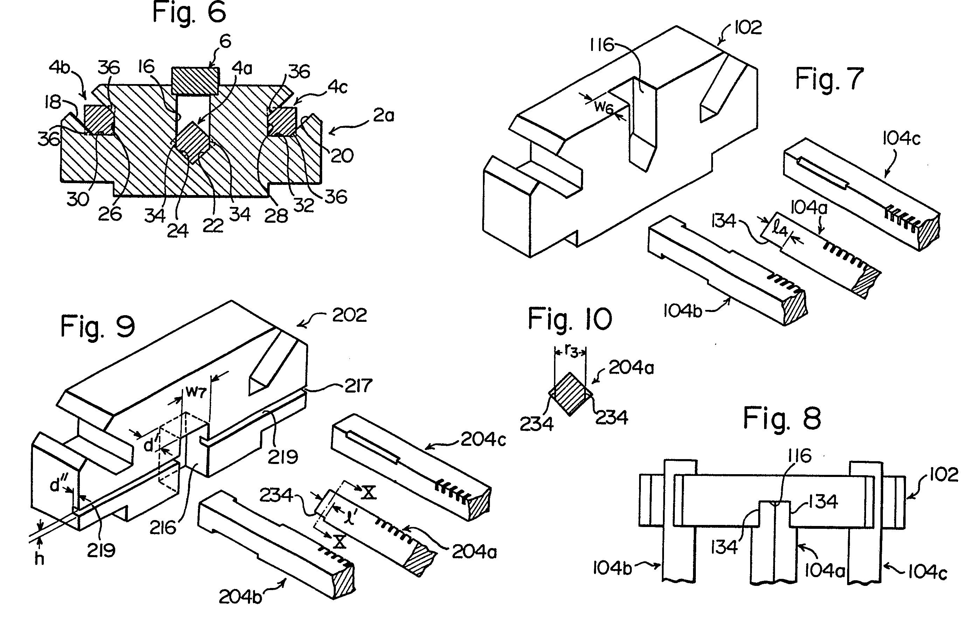

The two end supports 2a and 2b, the three rods 4a, 4b and 4c and the additional part 6 are assembled as shown in Figure 5 to form a device for supporting semiconductor wafers 52 or the like. With reference to Figure 6 which is a sectional view taken along line IV-IV of Figure 5 together with Figures 1 and 5, the two end supports 2a and 2b are set with a predetermined distance therebetween in the front and rear directions. The centrally located rod 4a is

- 11 -

combined with the end supports 2a and 2b by aligning
the two engaging notches 34 formed at the opposite
ends of the rod 4a with the central supporting notches
16 formed in the end supports 2a and 2b, and inserting
them into the central supporting notches 16 from above.
Consequently, as is easily understood from Figure 6,
the bottom surfaces of the two engaging notches 34
are positioned adjacent to, or in contact with, the
two side surfaces of the central supporting notches
16, and the two adjoining non-notched surfaces of the
lower portion of the rod 4a are brought into contact
with the two inclined planes 22 and 24 defining the
bottom of the central supporting notch 16. Thus, the
rod 4a is supported with sufficient stability in the
state shown in Figures 5 and 6 in which that corner
portion in which the holding grooves 38 are formed
is positioned uppermost. Furthermore, since the non-
notched portions at both ends of the rod 4a are
located exteriorly of the front and rear directions
of the end supports 2a and 2b, the rod 4a is prevented
from moving in the front and rear directions with
respect to the end supports 2a and 2b. The rod 4b
on one side is combined with the end supports 2a and
2b by aligning the two engaging notches 36 formed at
the opposite end portions of the rod 4b with the side
supporting notches 18 formed in the supports 2a and 2b,
and inserting them into the side supporting notches
18. Consequently, as can be easily understood from
Figure 6, the bottom surfaces of the two notches 36
are positioned adjacent to, or in contace with, the
two side surfaces of the side supporting notches 18,
and the two adjoining non-notched surfaces of the rod
4b at its inside and under side are brought into
contact with the substantially vertical plane 26 and
the substantially horizontal plane 30 defining the bottom of each side supporting notch 18. Thus, the rod 4b is supported with sufficient stability in the state shown in Figures 5 and 6 in which that corner portion in which the holding grooves 40 are formed is located at the inward top end of the rod 4b. Furthermore, since the non-notched portions at both ends of the rod 4b are located exteriorly of the front and rear directions of the end supports 2a and 2b, the rod 4b is prevented from moving in the front and rear directions with respect to the end supports 2a and 2b. Likewise, the rod 4c located on the other side is combined with the end supports 2a and 2b by aligning the two engaging notches 36 formed at the opposite end portions of the rod 4b with the side supporting notches 20 formed in the end supports 2a and 2b, and inserting them into the side supporting notches 20. Consequently, as can be seen easily from Figure 6, the bottom surfaces of the two notches 36 are positioned adjacent to, or in contact with, the two side surfaces of the side supporting notches 20, and the two adjoining non-notched surfaces of the rod 4c at its inside and underside are brought into contact with the substantially vertical plane 28 and the substantially horizontal plane 32 defining the bottom of each side supporting notch 20. Consequently, the rod 4c is supported with sufficient stability in the state shown in Figures 5 and 6 in which that corner portion in which the holding grooves are formed is positioned at the inward top end of the rod 4c. Since the non-notched portions at both ends of the rod 4c are positioned exteriorly of the front and rear directions of the end supports 2a and 2b, the rod 4c is prevented from moving in the front and rear directions with respect to the end supports 2a and 2b. It will be easily understood from Figures 5

- 13 -

and 6 that in the illustrated embodiment, the three rods 4a, 4b and 4c extend substantially horizontally and in parallel with each other across the two end supports 2a and 2b. The three rods 4a, 4b and 4c are located at substantially equal intervals, and thus the distance between the rods 4a and 4b is substantially equal to the distance between the rods 4a and 4c. The two rods 4b and 4c on both sides are located on the same level. The centrally located rod 4a, however, is on a lower level than the two rods 4b and 4c.

The additional part 6 is combined with the end support 2a by bringing the engaging notch 50 formed on the under surface of its engaging portion 48 into engagement with the supporting notch 42 of the end support 2a. It will be easily understood that when the engaging notch 50 is engaged with the supporting notch 42, the additional part 6 is prevented from moving in the front and rear directions and the lateral direction with respect to the end support 2a, and thus maintained stable on the end support 2a.

Preferably, the various component parts constituting the assembled device which can be freely disassembled, that is, the two end supports 2a and 2b, the three rods 4a, 4b and 4c and the additional part 6, are made of silicon. If desired, these various parts may be formed of quartz glass instead of silicon. In the case of using quartz glass, the rods 4a, 4b and 4c may, if desired, be reinforced with a suitable reinforcing material such as a metallic materail or heat-resistant fibers extending longitudinally in the quartz glass in order to increase their strength.

In subjecting a plurality of semiconductor wafers to a diffusion treatment by utilizing the

- 14 -

assembled device described above, the peripheral portion of one wafer 52 is inserted in a set of three holding grooves (i.e., one holding groove 38 and two holding grooves 40), which are aligned laterally, in the holding grooves 38 and 40 formed on the rods 4a, 4b and 4c. In this manner, a plurality of wafers 52 are supported in juxtaposition at predetermined intervals in the front and rear directions of the rods 4a, 4b and 4c. Each wafer 52 nearly disc-like in shape is inserted in the aforesaid set of holding grooves 38 and 40 at three circumferentially spaced positions in its lower peripheral portion, and therefore, is supported accurately in the required state. Then, by using an inserting instrument (not shown) known per se, the assembled device supporting the plurality of wafers 52 is pushed forwardly and put into a lateral diffusion furnace (not shown) extending substantially horizontally. The additional part 6 combined with the end support 2a can be utilized when the assembled device supporting the wafers is withdrawn from the diffusion furnace after the diffusion treatment. Specifically, the assembled device can be withdrawn from the diffusion furnace by hooking the opening 44 of the additional part 6 with a hook-like portion formed at the tip of a withdrawing instrument (not shown) known per se, and pulling the device. If desired, the additional part 6 may be omitted, and the assembled device may be withdrawn from the diffusion furnace by hooking a suitable site of the end support 2a, etc. with the hook-like tip portion of the withdrawing instrument. When a plurality of assembled devices each supporting a plurality of wafers are placed on a common mother boat and the mother boat is put into a diffusion furnace as described hereinbelow, the additional

- 15 -

part 6 is, of course, unnecessary.

To clean, transport or otherwise handling the assembled device, it may, if desired, be disassembled into its component parts. The disassembling operation can be very easily carried out by performing the aforesaid assembling operation reversely.

The following advantages can be obtained by the assembled device constructed in accordance with this invention. Since the various parts constituting the assembled device have relatively simple shapes, they can be produced relatively easily at low cost. When compared with the case of producing the entire device as a one-piece structure from a single block, the amount of the considerably expensive material can be drastically decreased, and therefore, the cost of production can be greatly reduced. The various components can be assembled and disassembled very easily. When the device has undergone local damage by exposure to great heat variation, etc., it is sufficient to exchange only that part which has been damaged, and the device can be further used. This offers an economical advantage. It is also noteworthy that the assembled device constructed in accordance with this invention undergoes a much lesser degree of damage than a device constructed as a one-piece structure when exposed to great heat variations. No clear reason has yet been assigned to this fact. It is theorized however that in the device constructed as a one-piece structure, thermal expansions or thermal shrinkages of various portions interact to exert a considerably great stress on these portions, but in the assembled device constructed in accordance with this invention, the thermal expansions or thermal shrinkages of the various component parts are effectively compensated for by the so-called "plays"

- 16 -

necessarily formed at joining parts of the various components parts owing to production tolerances.

The device constructed in accordance with this invention also brings about the following advantage. When wafers or the like to be supported have different diameters, the relative positions of the rods, particularly the lateral distances between the rods, should be made to correspond to the diameters of the wafers or the like, as can be easily understood from Figure 5. In this case, the relative positions of the rods in the assembled device can be properly changed by using another pair of end supports having a central supporting notch and side supporting notches at different relative positions. In other words, it is possible to deal with wafers of different diameters or the like by only exchanging the end supports with another set of end supports having different relative positions of the central supporting notch and side supporting notches, and there is no need to exchange the rods themselves.

In the aforesaid embodiment described with reference to Figures 1 to 6, the three rods 4a, 4b and 4c extending across the two end supports 2a and 2b are used. If desired, the centrally located rod 4a may be omitted, or four or more rods extending across the two end supports 2a and 2b may be used.

In the aforesaid embodiment, the holding grooves 38 and 40 are formed in all of the three rods 4a, 4b and 4c. It is also possible, for example, to form holding grooves 38 only in the centrally located rod 4a, and to make the two rods 4b and 4c located on both sides highly resistant to friction by, for example, knurling their surfaces finely instead of forming holding grooves 40 so that the edges of the wafers or the like are held by the rods 4b and 4c without slippage.

Furthermore, in the above embodiment, the holding grooves 38 and 40 are formed on the corner portions of the rods 4a, 4b and 4c having a square cross-sectional shape. If desired, instead of the above embodiment, the holding grooves may be formed on the flat surface portions of the rods 4a, 4b and 4c. In this regard, however, the following fact should be noted. In the above-described embodiment in which holding grooves are formed in the corner portions of the rods 4a, 4b and 4c, the amount of the material to be cut off from the rods 4a, 4b and 4c in order to form holding grooves of a predetermined depth can be much smaller than in the case of forming such grooves on the flat surface-portions of the rods 4a, 4b and 4c. This means that grooves can be formed on the corner portions of the rods 4a, 4b and 4c more easily and rapidly than on thire flat surface portions, and the reduction of the strength of the rods 4a, 4b and 4c owing to the formation the holding grooves can be lessened as compared with the case of forming the grooves on their flat surfaces.

In the above embodiment, the end portions of the rods 4a, 4b and 4c are combined with the end supports 2a and 2b by forming the supporting notches 16, 18 and 20 in the end supports 2a and 2b and the engaging notches 34 and 36 in the end portions of the rods 4a, 4b and 4c. But combining of the end portions of the rods 4a, 4b and 4c with the end supports 2a and 2b in a detachable manner can be effected by various other methods.

Figure 7 shows a modified example of the manner of combining an end support 102 with a centrally located rod 104a. In the modified example illustrated in Figure 7, a central supporting notch 116 formed in the end support 102 is formed not entirely over the thickness of the end support 102, but only on the inward side of the end support 102. On the other hand, the centrally located rod 104a is somewhat shorter than two rods 104b and 104c positioned on both sides of the rod 104a. Two engaging notches 134 are formed at the end portion of the rod 104a without leaving non-notched portions at its end (see Figure 8 also). The longitudinal size $\ell_4$ of each of the engaging notches 134 is substantially equal to, or slightly larger than, the size w6 of the supporting notch 116 in the front and rear directions. In this modified example, too, the end portion of the centrally located rod 104a is combined with the end support 102 by aligning the two engaging notches 134 formed therein with the central supporting notch 116 and inserting them into the central supporting notch 116 from above, as shown in Figure 8. The other end portion (not shown) of the centrally located rod 104a is combined with another end support (not shown) by the same method as above. The manner of combining the end portions of the two rods 104b and 104c located on both sides of the rod 104a with the end support 102 and other constructions may be the same as in the above embodiment shown in Figures 1 to 6.

It will be readily seen that in the modified embodiment shown in Figures 7 and 8, the relative movement of the rod 104a and the end support 102 in the front and rear directions cannot be directly hampered by the combination of the end portion of the centrally located rod 104 with the end support 102, and the end support 102 can be relatively moved away from the rod 104a. However, by the combination of the end portion of each of the rods 104b and 104c with the end support 102 in the same manner as in the embodiment shown in Figures 1 to 6, the relative movement of the rods 104b and 104c and the end support 102 in the front and rear directions is prevented, whereby the relative movement of the rod 104a and the end support 102 in the front and rear directions is indirectly prevented. Accordingly, the end portion of the centrally located rod 104a can also be combined with the end support 102 with sufficient stability. On the other hand, in the modified example illustrated in Figures 7 and 8, the central supporting notch 116 formed in the end support 102 does not extend over the entire thickness of the end support 102 but exists only in its inner side. Hence, the reduction of the strength of the end support 102 owing to the formation of the central supporting notch 116 is considerably lessened. Thus, the end support 102 shown in Figures 7 and 8 has higher strength than the end supports 2a and 2b shown in Figures 1, 5 and 6.

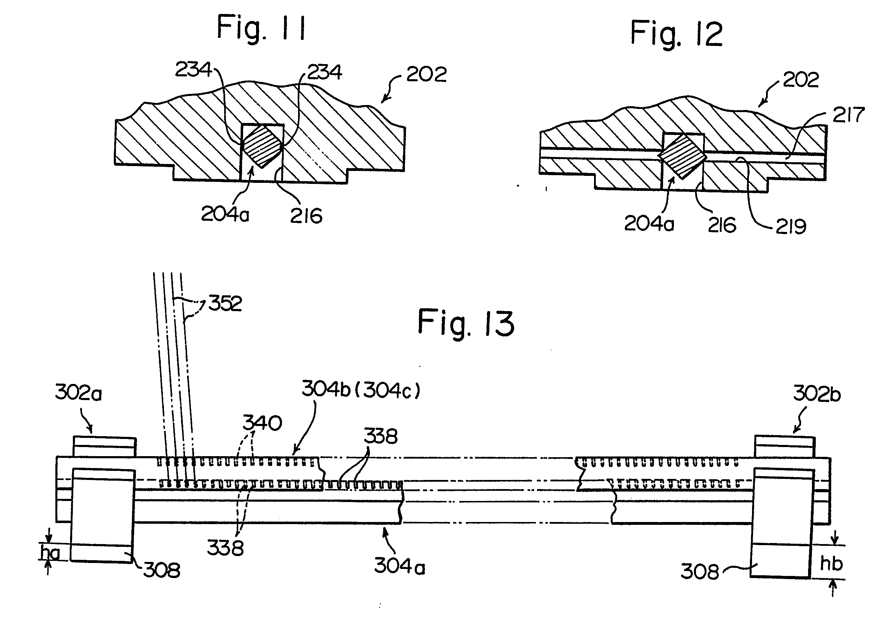

Figure 9 shows another modified example of the manner of combining an end support 202 with a centrally located rod 204a. In the modified example shown in Figure 9, a central supporting notch 216 formed in the end support 202 extends upwardly substantially vertically to a predetermined height from the central portion of the lower edge of the end support 202 instead of extending downwardly from the central portion of the upper edge of the end support 202. In addition, the central supporting notch 216 is formed not over the entire thickness of the end support 202 by only in the inner side surface of the end support 202, as in the modified example shown in Figures 7 and 8. The centrally located rod 204a, as in the modified example shown in Figures 7 and 8, is slightly shorter than two rods 204b and 204c located on both sides of the rod 204a, and two engaging notches 234 are formed at the end portion of the centrally located rod 204a without leaving non-notched portions at its end. As is celarly seen from Figure 10 which is a sectional view taken along line X-X of Figure 9, the two engaging notches 234 are formed in those corner portions of the rod 204a which are positioned at its lateral sides. The longitudinal size $\ell'$ of each of the engaging notches 234 is slightly smaller than the depth d' of the central supporting notch 216. Furthermore, in the modified example shown in Figure 9, a channel 217 is formed which extends in the inside surface of the end support 202 laterally and substantially horizontally and crosses the central supporting notch 216. An upwardly facing bottom surface 219 of the channel 217 defines a shoulder portion for supporting the end portion of the centrally located rod 204a as will be seen from the following description. The depth d" of the channel 217 is slightly smaller than the depth d' of the central supporting notch 216.

In this modified example, the end portion of the centrally located rod 204a is combined with the end support 202 in the following manner. The end of the rod 204a is positioned as required with respect to the inside surface of the end support 202. Then, the rod 204a is advanced longitudinally relative to the end support 202 and inserted in the central supporing notch 216. As a result, since the residual thickness r2 (Figure 10) between the two engaging notches 234 is substantially equal to, or slightly smaller than, the width w7 of the central supporting notch 216, the notched end portion of the rod 204a having the two engaging notches 234 formed therein advances to a deep site of the central supporting notch 216 beyond the channel 217 as shown in Figure 11.

- 21 -

On the other hand, in the non-notched portion exsisting adjacent to, and immediately rearwardly of, the aforesaid notched end portion, the corner portions on both lateral sides are located laterally outwardly of the central supporting notch 216. However, when the corner portions existing on both lateral sides of the non-notched portion are received in the channel 217 as shown in Figure 12, the non-notched portion is also caused to advance to the inlet side of the central supporting notch 216. The corner portions existing on both lateral sides of the non-notched portion are positioned on a shoulder portion defined by the bottom surface 219 of the channel 217. Thus, the end portion of the rod 204a is prevented from falling downwardly, and combined with the end support 202 with sufficient stability. The other end portion (not shown) of the centrally located rod 204a is combined with another end support (not shown) in the same manner as above. The manner of combining the end portions of the two rods 204b and 204c located on both sides of the rod 204a with the end support 102 and other constructions may be the same as in the embodiment shown in Figures 1 to 6.

As will be easily understood, the centrally located rod 204a should generally be positioned on a lower level than the two rods 204b and 204c located on both sides thereof. Accordingly, when a central supporting notch is to be formed so as to extend downwardly from the upper edge of the end support 202 substantially vertically, the central supporting notch should extend to a considerable depth from the upper edge of the end support 202. Thus, a considerable amount of the material should be cut off from the end support 202 in order to form the central supporting notch. In contrast, when the end portion of the rod 204a is supported by utilizing the upwardly facing shoulder portion (i.e., the shoulder portion defined by the bottom surface 219 of the channel 217) as in the above modified example, the central supporting notch 216 may be formed so as to extend upwardly from the lower edge of the end support 202 instead of forming it so as to extend downwardly from the upper edge of the end support 202. Thus, the amount of material cut off from the end support 202 for the formation of the central supporting notch .216 can be decreased, and the reduction of the strength of the end support 202 owing to the formation of the central supporting notch 216 can be lessened.

In the embodiment described above with reference to Figures 1 to 6, the rods 4a, 4b and 4c extend substantially horizontally across the two end supports 2a and 2b. If desired, as in the modified example shown in Figure 31, rods 304a 304b and 304c may be caused to extend upwardly inclinedly at some angle (for example an angle of about 5 to 10 degrees) from an end support 302a toward an end support 302b.

By this modified construction, the following advantages can be obtained. The width w3 (Figure 4) of each of the holding grooves 38 and 40 formed in the rods 4a, 4b and 4c is generally set at a value slightly larger than the thickness of a wafer to be inserted therein. Even when the width w3 of each of the holding grooves 38 and 40 is made substantially equal to the thickness of the wafer, the width w3 of each of the holding grooves 38 and 40 will become slightly larger if the contaminated rods 4a, 4b and 4c are washed with a washing solution such as hydrofluoric acid. Accordingly, when as in the emvodiment shown in Figures 1 to 6 in which the rods 4a, 4b and 4c extend substantially horizontally,

- 23 -

a wafer is supported by inserting its lower peripheral edge portion in the holding grooves 38 and 40 having a width w3 slightly larger than the thickness of the wafer, the wafer does not become completely upstanding, and inclines toward the end support 2a or the end support 2b although to a very slight extent. If all of the wafers in the holding grooves incline in the same direction, the distances between the adjacent wafers are uniform throughout the rods, and no particular problem arises. However, it is usual that some wafers incline toward to end support 2a, and others, toward the end support 2a. In this situation, non-uniformity occurs in the distance between the wafers. This non-uniformity increases as the inclination of the wafers increases owing to the increase of the width (w3) of each of the holding grooves 38 and 40 which occurs as a result of washing the rods 4a, 4b and 4c as mentioned above. When the non-uniformity in the distance between the wafers becomes excessive, the diffusion treatment of the wafers in a diffusion furnace may become non-uniform. In contrast, when the rods 304a, 304b and 304c are made to incline upwardly at some angle from the end support 302a toward the end support 302b as shown in Figure 13, all the wafers supported on the rods 304a, 304b and 304c by being inserted at their lower peripheral edge portions into holding grooves 338 and 340 are positively inclined toward the end support 302a owing to the aforesaid inclination of the rods 304a, 304b and 304c. When all of the wafers 352 are inclined in the same direction, the distances between the wafers 352 are maintained sufficiently uniform even when the inclination of the wafers 352 become larger to some extent. Hence, the wafers can be uniformly subjected to a diffusion treatment in a diffusion furnace. Furthermore, since each of the wafers 352 is positively inclined toward the end support 302a, each of the wafers 352 does not become unsteady even by some vibration or the like, and the stability of supporting the wafers 352 is also increased. To incline the rods 304a, 304b and 304c upwardly from the end support 302 toward the end support 302b, the height hb of a base portion 308 of the end support 302b is made slightly larger than the height ha of a base portion 308 of the end support 302a. Alternatively, the supporting position (i.e., the height of the bottom of the supporting notch) of the rods 304a, 304b and 304c at the end support 302b may be made slightly higher than the supporting position of the rods 304a, 304b and 304c at the end support 302a.

If desired, in order to incline the wafers 352 supported on the rods 304a, 304b and 304c positively toward the end support 302a, hodling grooves 338 and 340 formed on the rods 304a, 304b and 304c may be inclined downwardly toward the end support 302 instead of inclining the above rods as shown in Figure 13.

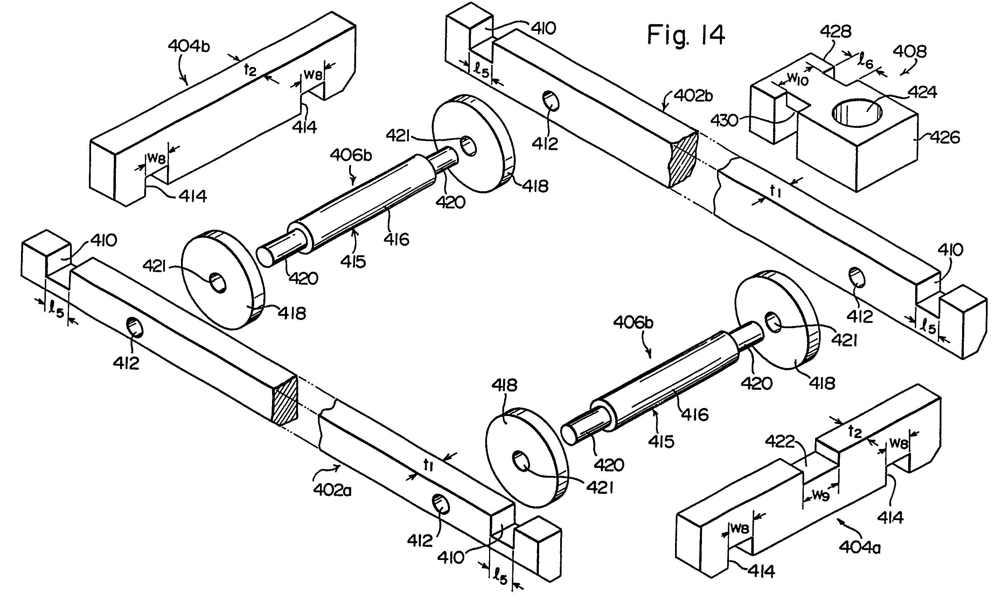

When a relatively large diffusion furnace is to be used, it is frequently the practice to place a plurality of assembled devices each supporting a plurality of wafers on a mother boat and put the mother boat into the diffusion furnace instead of putting the assembled device supporting a plurality of wafers directly into the diffusion furnace. Figure 14 shows by an exploded view one embodiment of the assembled mother boat constructed in accordance with this invention. The illustrated mother boat is comprised of a pair of side plates 402a and 402b, a pair of end plates 404a and 404b, a pair of wheel members 406a and 406b, and an additional part 408.

Each of the pair of side plates 402a and 402b spaced from each other laterally is of an elongated shape extending in the front and rear directions, preferably of a nearly rectangular cross-sectional shape. Supporting notches 410 are formed on the upper surfaces of the opposite end portions of each of the side plates 402a and 402b. Each of the supporting notches 410 may be substantially rectangular. Furthermore, each of the side plates 402a and 402b has formed therein two openings 412 spaced from each other at a predetermined distance therebetween in the front and rear directions and extending laterally therethrough. Each of these openings 412 has a circular cross-sectional shape.

The pair of end plates 404a and 404b spaced from each other in the front and rear directions extend laterally across the pair of side plates 402a and 402b. Conveniently, the pair of end plates 404a and 404b also have a nearly rectangular cross-sectional shape. Engaging notches 414 are formed on the opposite side portions of the under surface of each of the pair of end plates 404a and 404b, and each of such engaging notches 414 may be substantially rectangular. The lateral width $w8$ of each of the anchoring notches 414 is substantially equal to, or slightly larger than, the thickness $t1$ of each of the side plates 402a and 402b. On the ohter hand, the length $\ell_5$ in the front and rear directions of each of the notches 410 formed in the side plates 402a and 402b is substantially equal to, or slightly larger than, the thickness $t2$ of each of the end plates 404a and 404b.

Each of the pair of wheel members 406a and 406b spaced from each other in the front and rear directions includes a wheel shaft 415 and two wheels 418 mounted rotatably on the shaft 415. The shaft 415 has a large-diameter portion 416 and small-diameter portions 420 located on both sides of the large-diameter portion 416. Each of the wheels 418 has a hole 421 having an inside diameter corresponding to the outside diameter of the small-diameter portion 420. By inserting the small-diameter portion 420 through the hole 421, the wheel 418 is rotatably mounted on the shaft 415. The outside diameter of the small-diameter portion corresponds to the inside diameter of the opening 412 formed in the side plates 402a and 402b. If desired, the shaft 415 and the two wheels 418 may be formed as a one-piece unit.

In the illustrated embodiment, a supporting notch 422 which may be rectangular is formed centrally in the upper surface of the end plate 402 in order to combine the additonal part 408. The additional part 408 has a main portion 426 having a vertically extending opening 425 formed therein and a T-shaped engaging portion 428 projecting forwardly from the main portion. An engaging notch 430 which may be rectangular is formed in the under surface of the narrowed part of the engaging portion 428. The length $\ell_6$ in the front and rear directions of the engaging notch 430 is substantially equal to, or slightly larger than, the thickness t2 of the end plate 404a. On the other hand, the lateral width w9 of the supporting notch 422 formed centrally in the upper surface of the end plate 404a is substantially equal to, or slightly larger than, the lateral width w10 of the narrowed part of the engaging portion 428 of the additional part 408.

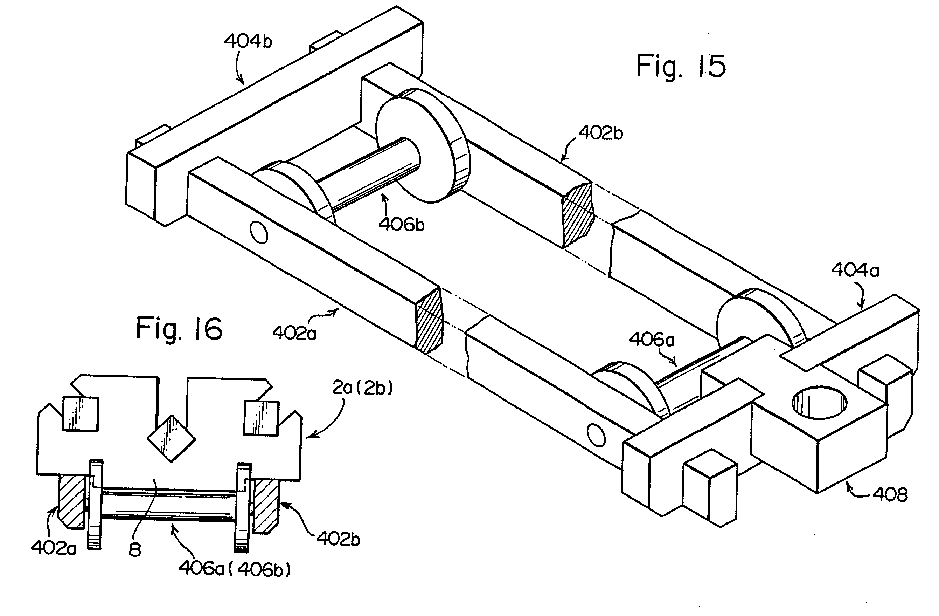

The pair of side plates 402a and 402b, the pair of end plates 404a and 404b and the additional part 408 are assembled as shown in Figure 15, and constitute an assembled mother boat. With reference to Figures 14 and 15, the pair of wheel members 406a and 406b are combined with the pair of side plates 402a and 402b by rotatably inserting the free end portions of the small-diameter portions 420 located on both side ends of each of the wheel members 406a and 406b into the corresponding openings 412 formed in the side plates 402a and 402b. As a result, the wheels 418 in the wheel members 406a and 406b are exactly prevented from being disengaged from the small-diameter portions 420 of the wheel shafts 415. The wheel members 406a and 406b are combined rotatably between the side plates 402a and 402b, and the side plates 402a and 402b are supported on both sides of the wheel members 406a and 406b. The end plate 404a is combined with one end portion each of the side plates 402a and 402b by engaging the engaging notches 414 formed at both side portions of its under surface with the supporting notches 410 formed on the upper surfaces of one end portions of the side plates 402a and 402b. The end plate 404b is combined with the other end portion of each of the side plates 402a and 402b by engaging the supporting notches 414 formed on both side portions of its under surface with the supporting notches 410 formed respectively on the upper surfaces of the other end portions of the side plates 402a and 402b. As will be easily understood, by engaging the engaging notches 414 with the supporting notches 410, the relative movement of the side plates 402a and 402b and the end plates 404a and 404b in the front and rear directions and the lateral direction is hampered, and the end plates 404a and 404b are stably supported by the side plates 402a and 402b. Furthermore, since the lateral movement of the side plates 402a and 402b is hampered, the wheel members 406a and 406b with the side plates 402a and 402b are stably combined. The additional part 408 is combined with the end plate 404a by engaging the engaging notch 430 formed in the under surface of its engaging portion 428 with the supporting notch 422 formed on the upper surface of the end plate 404a. When the engaging notch 430 is engaged with the supporting notch 422, the movement of the additonal part 408 in the front and rear directions and the lateral direction relative to the end plate 404a is prevented, and thus, the additional part 408 is stably supported by the end plate 404a.

The various component parts constituting the assembled mother boat which has been assembled as above in a disassemblable manner, i.e. the side plates 402a and 402b, the end plates 404a and 404b, the wheel members 406a and 406b, and the additional part 408, are preferably made of silicon. These various component parts may be made of quartz glass instead of silicon. In the case of using quartz glass, it is possible, if desired, to reinforce the quartz glass forming the side paltes 402a and 402b with a reinforcing material such as a metallic material or heat-resistant fibers extending longitudinally in the quartz glass, and thus to increase the strength of the side plates 402a and 402b.

A plurality of assembled devices of the type described hereinabove each supporting a plurality of wafers may be placed on the assembled mother boat in the front and rear directions in spaced-apart relationship. For example, when assembled devices of the type described hereinabove with reference to Figures 1 to 6 are to be placed on the assembled mother boat, the base portions 8 in the lower surfaces of the end supports 2a and 2b in each device are positioned between the pair of side plates 402a and 402b as shown in Figure 16, and the flat surfaces exisiting on both sides of each base portion 8 at the undersurfaces of the end supports 2a and 2b are brought into contact with the upper surfaces of the pair of side plates 402a and 402b. As a result, the device can be stably supported on the mother boat. If required, abutting blocks (not shown) may be provided in spaced-apart relationship on the side plates 402a and 402b in the front and rear directions so as to prevent exactly the relative movement of the device with respect to the mother boat in the front and rear directions. The mother boat on which a plurality of devices have been placed as required may be put into a substantially horizontally extending lateral diffusion furnace (not shown) by, for example, pushing it forwardly. The additional part 408 combined with the end plate 404 a can be utilized for withdrawing the mother boat from the diffusion furnace after the diffusion treatment. Specifically, the mother boat can be withdrawn from the diffusion furnace by hooking the opening 424 of the additional part 408 with a hook-like part formed at the tip of a withdrawing instrument (not shown) known per se, and pulling the instrument. If desired, the additional part 408 may be omitted, and the mother boat can be withdrawn from the diffusion furnace by hooking a suitable site of the end plate 404a, etc. with the hook-like tip portion of the withdrawing instrument.

When the assembled mother boat is to be cleaned, transported, or otherwise handled, it may, as required, be disassembled into the constituent parts. Such disassembling can be effected very easily by performing the aforesaid assembling operation reversely.

- 30 -

The assembled mother boat constructed in accordance with this invention achieves substantially the same advantages as already described with regard to the assembled device.

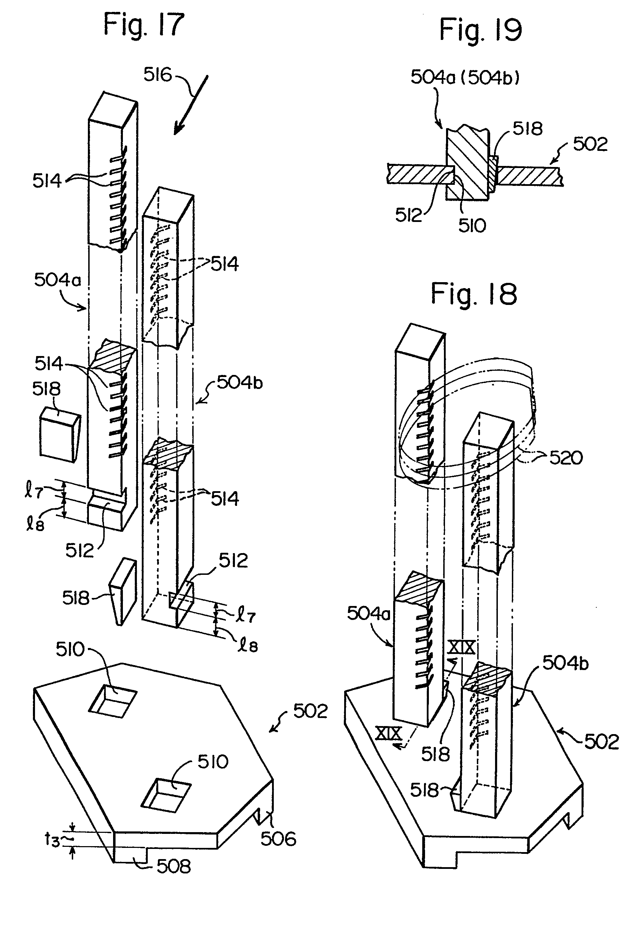

Substantially horizontally extending lateral diffusion furnaces have generally been used to subject semi-conductor wafers to a diffusion treatment. In recent years, a substantially vertically extending vertical diffusion furnace has also been developed and come into use. Figure 17 shows by an exploded view one embodiment of the assembled device of the invention for supporting semiconductor wafers or the like which can be applied to such a vertical furnace. The illustrated device includes one end support 502 and two rods 502a and 502b.

The end support 502 is in the form of a nearly flat plate. Supporting leg portions 506 and 508 projecting somewhat downwardly are formed in the front edge portion and the rear edge portion of the under surface of the end support 502. The main portion of the end support 502 has formed therein two vertically extending openings 510 which are used to cause the two rods 504a and 504b to stand upright on the end support 502 as will be described below. Each of the two openings 510 is conveniently of a substantially square cross-sectional shape corresponding to the cross-sectional shape of each of the two rods 504a and 504b, and they are conveniently disposed such that specified corner portions of these openings face each other as shown in Figure 17.

Each of the two rods 504a and 504b may have a suitable cross-sectional shape such as a circular or polygonal shape. Preferably, it has a rectangular, particularly square, cross-sectional shape from the standpoint of the ease of production and the ease of handling during assembling and disassembling.

An engaging notch 512 is formed on one surface of the lower end portion of each of the two rods 504a and 504b so as to combine it with the end support 502. The engaging notch 512 may be rectangular, and vertical length $\ell_7$ is substantially equal to, or slightly larger than, the thickness t3 of the main portion of the end support 502. The vertical length $\ell_8$ of a non-notched portion left at the lower end of each of the rods 504a and 504b is adjusted to a value smaller than the amount of downward protrusion of each of the supportint leg portions 506 and 508 of the end support 502. The rods 504a and 504b are arrenged such that one corner portion of the former faces one corner portion of the latter. A plurality of holding grooves 514 are formed at spaced intervals in the longitudinal direction, i.e. in the vertical direction, on those corner portions of the two rods 504a and 504b which face each other as described above. It is important that the holding grooves 514 formed on the rod 504a should be in lateral alignment with the holding grooves 514 formed on the rod 504b, respectively. Preferably, each of the holding grooves 514 is inclined at a certain angle (for example, an angle of 5 to 10 degrees) in the direction of inserting a wafer or the like into it, i.e. downwardly from the front end to the rear end viewed in the direction shown by an arrow 516 in Figure 17. Furthermore, as in the holding grooves 38 and 40 described with reference to Figure 4, the holding grooves 514 are preferably such that each groove is tapered to provide a gradually decreasing width from its open end to a certain predetermined depth, and has substantially the same width from the aforesaid predetermined depth to its bottom.

- 32 -

The illustrated device further includes two wedges 518 for use in combining the two rods 504a and 504b fully firmly with the end support.

The end support 502 and the two rods 504a and 504b are assembled as illustrated in Figure 18 to constitute a device for supporting semiconductor wafers 520 and the like. With reference to Figure 19 taken in conjunction with Figures 17 and 18, the lower end portion of each of the two rods 504a and 504b is inserted into each of the two openings 510 formed in the end support 502, and as clearly shown in Figure 19, each of the engaging notches 512 formed in the rods 504a and 504b is engaged in the main portion of the end support 502 along one edge of each of the openings 510. As a result, some space is formed along the ohter edge of each of the openings 510, and the wedge 518 is inserted in this space. Thus, the lower end portions of the two rods 504a and 504b are fully firmly combined with the end support 502, and the rods 504a and 504b ectend from the end support 502 parallel to each other, desirably substantially vertically upwardly.

The various component parts constituting the assembled device which has been assembled as above in a disassemblable manner, i.e. the end support 502, the two rods 504a and 504b and the two wedges 518, are preferably made of silicon. They may also be formed of quartz glass instead of silicon. In the case of using quartz glass, it is possible, if desired, to reinforce the quartz glass constituting the rods 504a and 504b with a suitable reinforcing material such as a metallic material or heat-resistant fibers extending longitudinally in the quartz glass, and thus to increase the strength of the rods 504a and 504b.

- 33 -

In subjecting a plurality of wafers to a diffusion treatment in a vertical diffusion furnace by utilizing the assembled device, a wafer 520 is moved in the direction of an arrow 516 as shown by the broken line in Figure 18, and inserted in a set of holding grooves 514 in the rods 504a and 504b. In this manner, a plurality of wafers 520 are supported in juxta-position at predetermined intervals in the upward direction. Since as described hereinabove, each of the holding grooves 514 is inclined downwardly from its forward end to its rear end in the direction shown by the arrow 516, each wafer 520 inserted in the holding groove 514 is positioned in such a state that its free end side is inclined upwardly. Hence, the wafer 520 is fully prevented from coming out of the holding groove 514 accidentally. It should be noted in this regard that when the holding groove 514 extends substantially horizontally and the wafer 520 inserted in, and supported by, it remains substantially horizontal, there is a great likelihood of the wafer 520 coming out of the holding groove 514 and thus falling from it. Disengagement of the wafer 520 in the direction of arrow 516 can be accurately prevented by making the distance between the holding groove 514 formed in the rod 504 and the corresponding holding member 514 formed in the rod 504 sufficiently smaller than the diameter of the wafer. After a plurality of wafers have been inserted in the assembled device, the assembled device is lifted by holding a suitable site of the assembled device, for example the upper ends of the rods 504a and 504b, by means of a suitable suspending device (not shown), and then caused to descend into the vertical diffusion furnace through an opening formed at its upper end, and the end support 502 is placed on the bottom wall of the diffusion furnace. Alternatively, it is possible to place the assembled device in the diffusion furnace while it is in the suspended state, and to close the aforesaid opening of the diffusion furnace in this state. After the diffusion treatment, the assembled device can be withdrawn from the diffusion furnace by raising it with the aforesaid suspending device.

When the assembled device is to be cleaned, transported or otherwise handled, it can as required, be disassembled by performing the aforesaid assembling operation reversely.

In the above assembled device, no end support is combined with the upper end portions of the rods 504a and 504b. If desired, however an end support similar to the end support 502 may be combined with the upper end portions of the rods 504a and 504b in the same manner of combining. Furthermore, when the assembled device is suspended by the aforesaid suspending device even during the insertion of wafers in the grooves, it is possible, if desired, to combine an end support only with the upper end portions of the rods 504a and 504b and to omit the end support 502 to be combined with their lower end portions.

In the above assembled device, two rods 504a and 504b are used. If desired, however, three or more rods arranged properly may be used.

In the assembled device to be applied to the vertical furnace, wafers supported on it are desirably in such a state that their free end sides incline upwardly, in order to prevent accidental disengagement of the wafers or the like from the assembled device, as already stated above. On the other hand, from the standpoint of loading wafers into the assembled device and their removal from it, especially from the standpoint of the ease of automatic loading and removal, it is desired to move wafers in a substantially vertical state or in a substantially horizontal state. In the assembled device described with reference to Figures 17 to 19, the holding grooves 514 formed in the rods 504a and 504b are inclined downwardly from their in front end to their in rear end viewed in the drection of inserting or loading wafers as indicated by arrow 516. Accordingly, when the wafers 520 are to be inserted into the holding grooves 514 and withdrawn from the holding grooves 514, it is generally necessary to incline the wafers 520 moved in the direction of arrow 516 in the same way as in the case of inclining the holding grooves 514, namely tō incline the wafers downwardly in the direction of arrow 516, and to move the wafers 520 relative to the holding grooves 514. It will be readily understood, however, that an automatic conveying mechanism, etc. known per se which are utilized in conveying wafers 520 can move wafers 520 in a substantially vertical state or in a substantially horizontal state, but with such a mechanism, it is considerably diffucult, if not impossible, to move wafers 520 in a state of inclination at a certain angle to the vertical or horizontal direction. In veiw of this fact, it is desired to develop an assembled device which can permit wafers to be loaded into and withdrawn from the device by moving them in a substantially vertical state or in a substantially horizontal state, and permit the free end sides of the wafers to be inclined upwardly when the wafers are supported in a diffusion furnace.

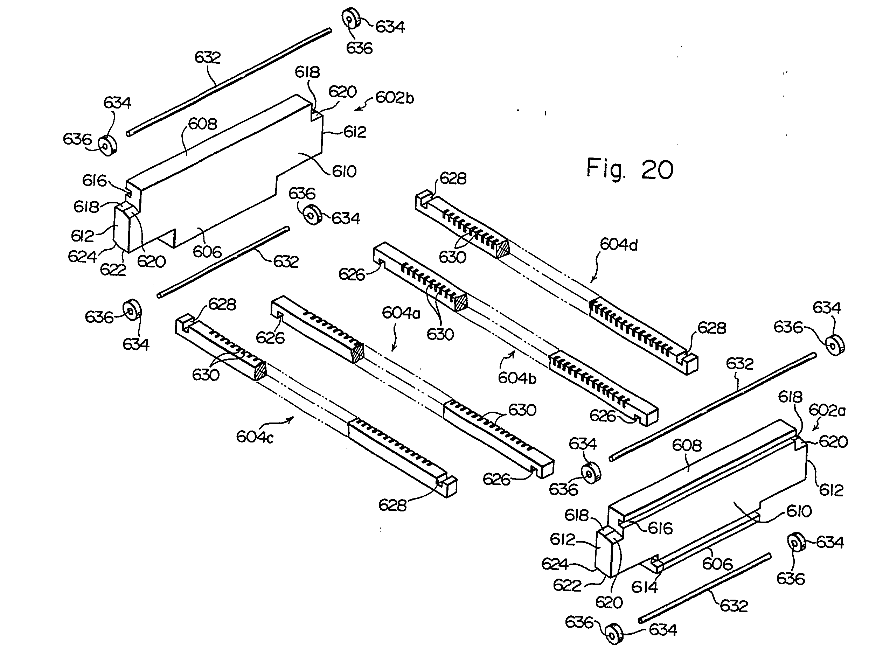

Figure 20 shows by an exploded view one embodiment of the assembled device constructed in accordance with this invention which meets the above

- 36 -

desire. The illustrated device includes two end supports 602a and 602b, and four rods 604a, 604b, 604c and 604d.

Each of the end supports 602a and 602b may be of a suitable shape, but conveniently of a nearly rectangular shape with a large width which enables the end support to stand stably in the state shown in Figure 20. Each of the end supports 602a and 602b has a first supporting portion 606 of a relatively narrow width at its lower part, a second supporting portion of a relatively large width at its upper part and an intermediate portion 610 located midway between the first and second supporting portions. At both sides of the intermediate portion 610, a projecting portion 612 projecting sideways beyond the first supporting portion 606 and the second supporting portion 608 is provided. A laterally extending channel 614 is formed on the outside surface of the first supporting portion 606, and likewise, a laterally extending channel 616 is formed on the outside surface of the second supporting portion 608. The channels 614 and 616 may be of a square cross-sectional shape. The upper surface of the projecting portion 612 provided on both sides of the intermediate portion 610 is defined by a horizontal surface 618 and an inclined surface 620. In the state shown in Figure 20, the horizontal surface 618 is substantially horizontal, and the inclined surface 620 is inclined downwardly toward the outside surface at a predetermined angle which may be about 5 to 10 degrees. The lower surface of the projecting portion 612 is defined by a horizontal surface 622 and an inclined surface 624. In the state shown in Figure 20, the horizontal surface 622 is substantially horizontal, and the inclined surface 624 is inclined upwardly toward the inside surface at a predetermined angle which may be about 5 to 10 degrees.

The four rods 604a, 604b, 604c and 604d may have a suitable cross-sectional shape such as a circular or polygonal shape. For the ease of production and the ease of handling in assembling and disassembling, they preferably have a rectangular, especially square, cross-sectional shape. Each of the centrally located two rods 604a and 604b has channels 620 formed on the under surfaces of its opposite end portions. Conveniently, each of the channels 626 have substantially the same square cross-sectional shape as the channel 614. Each of the two rods 604c and 604d located on both sides has channels 628 formed on the upper surfaces of its opposite ends. Conveniently, the channels 628 have substantially the same square cross-sectional shapes as the channel 616. A plurality of holding grooves 630 are formed longitudinally at predetermined intervals on the main portion of each of the four rods 604a, 604b, 604c and 604d. Conveniently, such holding grooves 630 are formed on those corner portions of these rods which are positioned at the inside top end of the rods in the state shown in Figure 20. Each of these holding grooves 630 extends vertically without inclining in the left and right directions in Figure 20. As in the holding grooves 38 and 40 described hereinabove with reference to Figure 4, each of the holding grooves 630 is tapered to provide a gradually decreasing width up to a predetermined depth from its open end, and has substantially the same width from the aforesaid predetermined depth to its bottom. It is important that the substantially same width from the predetermined depth to the bottom should be slightly larger than the thickness of a wafer or the like to be inserted therein.

- 38 -

The illustrated device further includes four linking shafts 632 and eight stop rings 634, which are used to combine the two opposite end portions of each of the four rods 604a, 604b, 604c and 604d with each of the end supports 602a and 602b detachably and pivotally over a predetermined angular range. Each of the four linking shafts 632 conveniently has a circular cross-sectional shape. Each of the eight stop rings 634 has formed therein a hole 636 having an inside diameter corresponding to the outside diameter of the linking shaft 632.

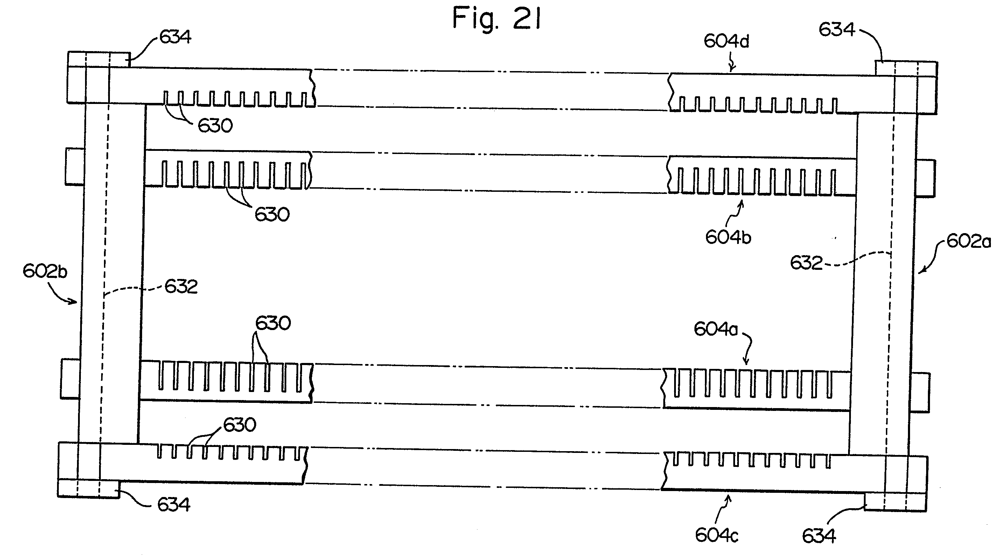

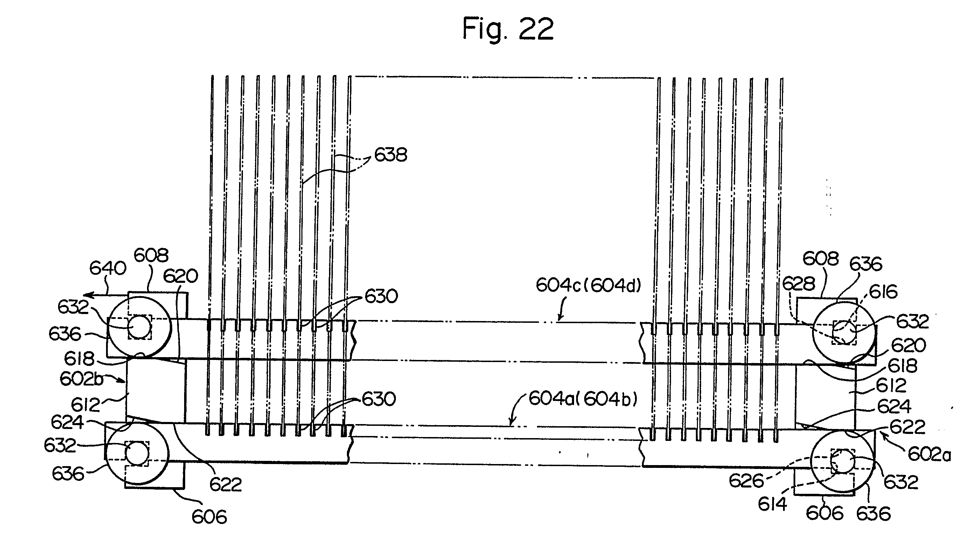

The two end supports 602a and 602b and the four rods 604a, 604b, 604c and 604d described above are assembled as shown in Figures 21 and 22 to constitute a device for supporting semiconductor wafers 638 or the like. With reference to Figures 21 and 22 taken in conjunction with Figure 20, the two end supports 602a and 602b are set upright so that they are positioned parallel to each other with a predetermined distance therebetween. The end portions of the centrally located rods 604a and 604b are caused to adjoin both side surfaces of the first support portion 606 of each of the end supports 602a and 602b, and the channel 626 formed on the under surface of each of the centrally located rods 604a and 604b is positioned in alignment with the channel 614 formed on the outside surface of the first supporting portion 606. The linking shaft 632 is inserted through the channels 614 and 629. Thus, the opposite end portions of each of the rods 604a and 604b are pivotally combined with the end supports 602a and 602b. Since the linking shaft 632 passes through the channel 626, the linking shaft 632 is prevented from being detached outwardly from the opening surface of the channel 614. Furthermore, the linking shaft 632 is prevented from being detached downwardly from the open surface of the channel 626 because the linking shaft 632 passes through the channel 614. To prevent the linking shaft 632 passed through the channels 614 and 626 from moving laterally, stop rings 634 are fixed respectively to the opposite ends of the linking shaft 632 projecting laterally beyond the rods 694a and 694b. Fixing of the stop rings 634 to the two opposite ends of the linking shaft 632 can be acheved by, for example, forming a male thread at the opposite ends of the linking shaft 632, forming a female thread in the holes 636 of the stop rings 634, and screwing the stop rings 634 to the opposite ends of the linking shaft 632. Alternatively, it is possible to form diameterically extending holes in the end portions of the stop rings 634 and the linking shaft 632 and insert stop pins into these holes. The two rods 604c and 604d located on both sides are positioned such that their in end portions are caused to adjoin both side surfaces of the second supporting portion 608 in each of the end supports 602a and 602b, and the channel 628 formed on the upper surface of each end portion of the rod is aligned with the channel 616 formed on the outside surface of the second supporting portion 608. The linking shaft 632 is inserted through the channels 616 and 628. As a result, the opposite end portions of each of the rods 604a and 604d are pivotally combined with each of the end supports 602a and 602b. Detachment of the linking shaft 632 outwardly from the open surface of the channel 616 is prevented by the passing of the linking shaft 632 through the channel 628. Furthermore, detachment of the linking shaft 632 upwardly from the open surface of the channel 628 is prevented by the passing of the linking shaft 632 through the channel 616.

- 40 -

Furthermore, in order to prevent the linking shaft 632 passed through the channels 616 and 628 from moving laterally, stop rings 634 are fixed to each of the two ends of the linking shaft 632 projecting laterally beyond the rods 604c and 604d.

The various components which constitute the assembled device assembled in the above-mentioned manner in a disassembable fashion are preferably made of silicon. The various components may also be formed of quartz glass instead of silicon. In the case of using quartz glass, it is possible, if desired, to reinforce the quartz glass constituting the rods 604a to 604d and the linking shaft 632 with a metallic material or heat-resistant fibers extending longitudinally in the quartz glass, and to increase the strength of these component parts.

The manner of using the aforesaid assembled device will be described. In loading wafers or the like into the device, the device is positioned laterally as illustrated in Figures 21 and 22, namely in the state in which the under surfaces of the first supporting portions 606 of the end supports 602a and 602b are kept in contact with a suitable, substantially horizontal supporting base surface to make the end supports 602a and 602b upstanding. In this laterally laid state, the four rods 604a, 604b, 604c and 604d extend substantially horizontally. The upper surfaces of the end portions of the centrally located two rods 604a and 604b contact or adjoin the lower horizontal surfaces 622 of the projecting prtions 612 of the end supports 602a and 602b. The lower surfaces of the end portions of the two rods 604c and 604d located on both sides contact or adjoin the upper horizontal surfaces 618 of the projecting portions 612 of the end supports 602a and 602b.

It is important that in this laterally laid state, the holding grooves 630 formed on the four rods 604a to 604d should be in lateral alignment as is clearly seen from Figures 21 and 22. It wll be readily seen that when the device is in the laterally laid state, four circumferentially spaced sites of the lower peripheral edge portion of a wafer 638 can be inserted into the four rods 604a, 604b, 604c and 604d by lowering the wafer 638 from above in a substantially vertical condition. Hence, wafers 638 can be automatically loaded into the device very easily.

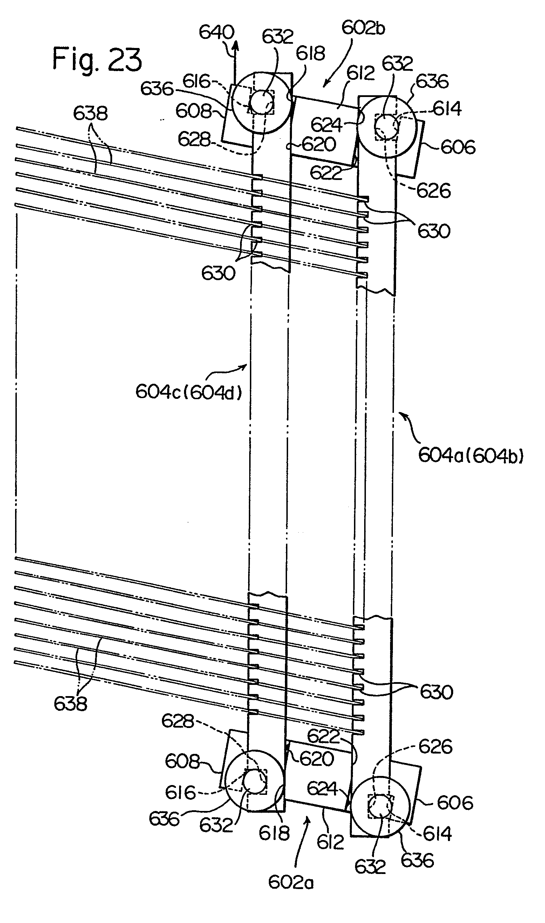

To put the device having wafers 638 loaded thereon into a vertical diffusion furnace, the upper end portion of the end support 602b is held by a suitable suspending device (not shown) and the device is lifted as shown by an arrow 640 in Figures 22 and 23. If required, in order to hold the end support 602b by the suspending device, at least one hole extending in the thickness direction may be formed, as required, on the upper end portion of the end support 602b. When the device is lifted as shown in Figure 22, the rods 604a, 604b, 604c and 604d pivot relatively over some angular range (for example, 5 to 10 degrees) owing to their own weight, and consequently, the device is suspended in the state shown in Figure 23. In this suspended state, the rods 604a, 604b, 604c and 604d extend substantially vertically, but the end supports 604a and 604b incline slightly downwardly from the second supporting portion 608 toward the first supporting portion 606. Thus, the upper surfaces (those on the right side in Figure 23) of the end portions of the two centrally located rods 602a and 602b make contact with the inclined surfaces 624 on the undersides (left side in Figure 23) of the projecting portions 612 in the end supports 602a and 602b, and the under surfaces (those on the left side in Figure 23) of the end portions of the two rods 604a and 604b located outside make contact with the inclined surfaces 630 on the upper sides (right side in Figure 23) of the projecting portions 612 in the end supports 602a and 602b. As a result, the end supports 602a and 602b can be prevented from pivoting relative to the rods 604a, 604b, 604c and 604d. Since in the suspended state shown in Figure 23, the end supports 602a and 602b incline slightly downwardly from the second supporting portion 608 toward the first supporting portion 606, the rods 604c and 604d located on both sides deviate slightly upwardly with respect to the centrally located rods 604a and 604b. Specifically, the rods 604c and 604d located forwardly when viewed in the direction of inserting wafers 638 deviates slightly upwardly with respect to the rods 604a and 604b located rearwardly when viewed in the aforesaid direction. Hence, the holding grooves 630 formed on the rods 604c and 604d deviate slightly upwardly with respect to the holding grooves 630 formed on the rods 604a and 604d. As a result, as clearly shown in Figure 23, the wafers 638 assume a state in which their free end sides incline upwardly. Hence, the wafers 638 are fully prevented from coming out accidentally from the device. Such inclination of the wafers 638 is permitted by making the width of each holding groove 630 slightly larger than the thickness of each wafer 638. The device is put into the diffusion furnace while it is in the suspended state, and is maintained in the suspended state in the furnace. After the diffusion treatment, the device is withdrawn from the diffusion furnace, and then maintained in the laterally laid state shown in Figures 21 and 22.  Afterwards, the wafers 638 which
have been subjected to diffusion, are taken out from
the device.  When the device is maintained in the
laterally laid state, the end supports 602a and 602b
and the rods 604a, 604b, 604c and 604d relatively
pivot over some angular range, and assume the state
shown in Figures 21 and 22.  As a result, the wafers
638 return to their substantially vertical state.
Accordingly, the wafers 638 can be takne out from the
device by raising them substantially vertically, and
this operation can be very easily carried out by
using an automated system.

In the manner of use described hereinabove,
the device is maintained in the laterally laid state
shown in Figures 21 and 23 when wafers 638 are loaded
into, and taken out from, the device.  If desired,
the following alternative may be performed.  The
device is maintained suspended when the wafers 638
are loaded into, and taken out from, the device.  By
contacting the lower ends (in Figure 23) of all of
the rods 604a, 604b, 604c and 604d with a substantially
horizontal supporting base surface to maintain the
relative relation between the end supports 602a and
602b and the rods 604a, 604b, 604c and 604d as shown
in Figures 21 and 22.  Consequently, the heights of
the holding grooves 630 formed on the rods 604a, 604b,
604c and 604d become substantially the same, and
therefore, by moving the substantially horizontally
disposed wafers 638 in the substantially horizontal
direction, the wafers 638 can be loaded into, and
taken out from, the device automatically with
sufficient ease.

While the present invention has been described
in detail hereinabove with reference to some specific
embodiments taken in conjunction with the accompanying

- 44 -

drawings, it should be understood that various changes and modifications are possible without depearting from the scope of the invention.

- 1 -

WHAT IS CLAIMED IS:

1. An assembled device for supporting semiconductor wafers or the like, said device comprising two end supports spaced from each other horizontally with a predetermined distance therebetween and at least two rods extending across said end supports with one end portion of each rod being detachably combined with one of said end supports and the other end portion thereof being detachably combined with the other end support, at least one of said rods having formed therein a plurality of holding grooves spaced longitudinally thereof.

2. The assembled device of claim 1 which contains three rods extending substantially parallel to each other across said end supports.

3. The assembled device of claim 2 wherein the two rods positioned on both sides are substantially on the same level, and the centrally located rods is on a lower level than the two rods positioned on both sides.

4. The assembled device of claim 1 wherein the rods extend substantially horizontally.

5. The assembled device of claim 1 wherein each rod extends inclinedly from said one end portion to said other end portion.

6. The assembled device of claim 1 wherein each of holding grooves is tapered so that its width gradually decreases from its open end to a predetermined depth, and has substantially the same width from said predetermined depth to its bottom.

7. The assembled device of claim 1 wherein the rods have a rectangular cross-sectional shape, and the holding grooves are formed on one corner portion of each rod.

8.. The assembled device of claim 1 wherein each of said end supports has formed therein at least two supporting notches extending from its edge, and the end portions of each of said rods are combined with each of the end supports by inserting them into said supporting notches.

9.. The assembled device of claim 8 wherein the device includes three rods extending substantially parallel to each other across said end supports, the two rods located on both sides are substantially on the same level and the centrally located rod is on a lower level than said two rods located on both sides;

each of said supports has two side supporting notches extending downwardly and centrally from both side portions of its upper edge in an inclined manner and a central supporting notch extending substantially vertically downwardly from the central portion of its upper edge; and

each end portion of each of the two rods located on both sides is combined with each of said end supports by inserting it into each of said side supporting notches, and each end portion of the centrally located rod is combined with each of the end supports by inserting it into the central supporting notch.

10. The assembled device of claim 9 wherein the two side portions of the upper edge of each of said end supports are inclined downwardly.

11. The assembled device of claim 9 wherein each of the side supporting notches is formed over the entire thickness of said end support, each end portion of each of the rods located on both sides has formed therein an engaging notch having a longitudinal size corresponding to the size of each said side supporting notch in its thickness direction with a non-notched portion left at its end, and by engaging the engaging notch with the supporting notch, the longitudinal movement of each of the two rods located on both sides relative to each of said end supports is prevented.

12. The assembled device of claim 9 wherein said central supporting notch is formed only on the inside surface of said end support, and each end portion of the centrally located rod has formed therein an engaging notch having a longitudinal size corresponding to the size of the central supporting notch without leaving a non-notched portion at its end.

13. The assembled device of claim 12 wherein each of the rods has a rectangular cross-sectional shape, each end portion of each rod has two engaging notches resulting from cutting off two diagonally opposing corner portions to provide flat surfaces substantially perpendicular to the diagonal line, and the width of each of the central and side supporting notches formed in each of said end supports corresponds to the residual thickness between said two engaging notches.

14. The assembled device of claim 13 wherein the bottom of each side supporting notch formed in each of said end supports is defined by a substantially horizontal first plane and a substantially vertical second plane, the adjoining two non-notched surfaces at each end portion of each of the two rods located on both sides are kept in contact with said first plane and said second plane and positioned at said side supporting notches, and the holding grooves are formed on the top inner corner portions of each of the rods located on both sides.

15. The assembled device of claim 13 wherein the bottom of the central notch formed in each of said end supports is defined by two inclined planes extending inclinedly upwardly toward both sides at an angle of substantially 45 degrees to the horizontal; each end portion of the centrally located rod is kept in contact at tis two adjoining non-notched surfaces with the two inclined planes and thus positioned in the central supporting notch; and the holding grooves are formed on that corner portion of the centrally located rod which is located uppermost.

16. The assembled device of claim 8 wherein the device includes three rods extending substantially parallel to each other across said end supports, the two rods located on both sides are on substantially the same level, and the centrally located rod is on a lower level than the two rods located on both sides;

each of said end supports has formed therein two side supporting notches extending downwardly and centrally from both side portions of its upper edge in an inclined manner and a central supporting notch extending substantially vertically at the central portion of each said end support; and,

each end portion of each of the two rods located on both sides is combined with each of the end supports by inserting it into each side supporting notch, and each end portion of the centrally located rod is combined with each of said end supports by inserting it in the central supporting notch.

17. The assembled device of claim 16 wherein a supporting shoulder portion facing upwardly at the intermediate portion of the central supporting notch in the height direction is provided in at leanst one plane of each of the end supports;

each end portion of the centrally located rod has formed therein an engaging notch so as to form in a specified direction a residual thickness corresponding to the width of the central supporting notch; and,

each end portion of the centrally located rod is combined with each of said end supports by engaging the engaging notch with the central supporting notch and positioning both side portion of a non-notched portion adjacent to the engaging notch as viewed in the longitudinal direction on said supporting shoulder portion.

18. The assembled device of claim 17 wherein the supporting shoulder portion is provided on the inside plane of each of the end supports.

19. The assembled device of claim 16 wherein both side portions of the upper edge of each of the end supports are inclined downwardly.

20. The assembled device of claim 16 wherein each of the side supporting notches is formed over the entire thickness of said end support, each end portion of each of the rods located on both sides has formed therein an engaging notch having a longitudinal size corresponding to the size of each side supporting notch in its thickness direction leaving a non-notched portion at its end, and by engaging the engaging notch with the supporting notch, the longitudinal movement of each of the rods located on both sides to each of the end supports is prevented.

21. The assembled device of claim 20 wherein said central supporting notch is formed only on the inside surface of said end support, and each end portion of the centrally located rod has formed therin an engaging notch having a longitudinal size slightly smaller than the size of the central supporting notch in its thickness direction without leaving a non-notched portion at its end.

22. The assembled device of claim 21 wherein each of the rods has a rectangular cross-sectional shape, each end portion of each rod has formed therein two engaging notches resulting from cutting off two diagonally opposing corner portions to provide planes substantially perpendicular to the diagonal line, and the width of each of the supporting notches formed in each of the end supports corresponds to the residual thickness between the two engaging notches.

23. The assembled device of claim 22 wherein the bottom of each side supporting notches formed in each of said end supports is defined by a substantially horizontal first plane and a substantially perpendicular second plane, each end portion of each of the two rods located on both sides is kept in contact at its two adjoining non-notched surfaces with the first plane and the second plane and thus positioned in the side supporting notch, and the holding grooves are formed on the top inner corner portions of each of the two rods located on both sides.

24. The assembled device of claim 22 wherein the holding grooves are formed on that corner portion of the centrally located rod which is located uppermost.

25. An assembled mother boat on which to place devices for supporting semiconductor wafers or the like, said boat comprising a pair of side plates spaced laterally from each other, a pair of end plates spaced from each other in the front and rear directions, and a pair of wheel members spaced from each other in the front and rear directions, said pair of side plates being detachably combined with said pair of end plates so that their relative movements in the front and rear directions and the lateral direction can be prevented, and said pair of wheel members being located between, and rotatably combined with, said pair of side plates.

26. The assembled mother boat of claim 25 wherein each of said pair of side plates has formed therein two circular openings extending laterally and spaced from each other in the front and rear directions, a small-diameter shaft portion having an outside diameter corresponding to the inside diameter of each circular opening is formed on both ends of each of the wheel members, and by inserting the small-diameter shaft portion into the circular opening, the pair of wheel members are combined with the pair of side plates.

27. The assembled mother boat of claim 25 wherein two supporting notches spaced from each other in the front and rear directions are formed on the upper surface of each of the pair of side plates, two laterally spaced engaging notches are formed on the lower surfaces of each of the pair of end plates, and the pair of side plates are combined with the pair of end plates by engaging the supporting notches with the engaging notches.

28. The assembled mother boat of claim 27 wherein the supportingnotches are rectangular, the length in the front and rear directions of each of the supoorting notches corresponds to the thickness of each of the end plates, the engaging notches are rectangular, and the lateral width of each of the engaging notches corresponds to the thickness of each of the side plates.

29. An assembled device for supporting semiconductor wafers or the like, said device comprising at least one end support, and at least two rods each extending substantially vertically from one end portion thereof combined detachably with said end support, each of said rods having formed therein a plurality of holding grooves spaced from each other longitudinally thereof.

30. The assembled device of claim 29 wherein said rods extend substantially parallel to each other.

31. The assembled device of claim 29 wherein each of said holding grooves extends downwardly from its front end to its rear end viewed in the direction of inserting wafers or the like into each groove.

32. The assembled device of claim 29 wherein each of said holding grooves is tapered so that its width gradually decreases from its open end to a predetermined depth, and has substantially the same width from said predetermined depth to its bottom.

33. The assembled device of claim 29 wherein the rods have a rectangular cross-sectional shape, and the holding grooves are formed on one corner portion of each rod.

34. An assembled device for supporting semiconductor wafers or the like, said device comprising two end supports spaced from each other and at least two rods each extending across said end supports with one end portion thereof being combined detachably with one of said end supports and the other end portion being detachably combined with the other end support, each of said rods having formed therein a plurality of holding grooves spaced longitudinally thereof, and said end supports being spaced from each other vertically so that said rods extend substantially vertically.

35. The assembled device of claim 34 wherein the device includes at least three rods extending substantially parallel to each other across said end supports, and at least one rod is located rearwardly of the other rods when viewed in the direction of loading wafers or the like into the device and taking them out therefrom.

36. The assembled device of claim 35 wherein the end supports and the end portions of the rods are combined with each other pivotally over a predetermined angular range, and said device can assume either a first state in which the holding grooves formed in the individual rods are aligned with each other, and a second state in which the end supports and the end portions of the rods relatively pivot over said predetermined angular range from said first state, and the holding grooves formed on the rod located rearwardly when viewed in the direction of loading wafers or the like into the device and taking them out therefrom deviate in a predetermined direction with respect to the holding grooves formed on the rods located forwardly in said direction.

37. The assembled device of claim 36 wherein in a laterally laid state in which the rods extend substantially horizontally, the device assumes said first state, and when the rods are maintained in the suspended state in which they extend substantially vertically by suspending a predetermined position of one of said end supports, the device assumes said second state by its own weight, and wherein in the second state, the holding grooves formed on the rod located rearwardly deviate downwardly with respect to the holding grooves formed on the rods located forwardly.

38. The assembled device of claim 34 wherein each of the holding grooves is tapered so that its width decreases gradually from its open end to a predetermined depth, and has substantially the same width from said predetermined depth to its bottom.

39. The assembled device of claim 34 wherein the rods have a rectangular cross-sectional shape, and the holding grooves are formed on one corner portion of each of the rods.

Fig. I

Fig. 2

Fig. 3

0100539

Fig. 5

Fig. 4

Fig. 6

Fig. 7

Fig. 8

Fig. 9

Fig. 10

Fig. 11

Fig. 12

Fig. 13

0100539

0100539

Fig. 14

Fig. 15

Fig. 16

Fig. 17

Fig. 19

Fig. 18

Fig. 20

Fig. 21

Fig. 22

Fig. 23